# EUROPÄISCHE PATENTSCHRIFT

(11) **EP 1 565 937 B1**
(45) Veröffentlichungstag und Bekanntmachung des Hinweises auf die Patenterteilung: **18.04.2007**
(21) Anmeldenummer: 03753204.1
(22) Anmeldetag: 27.10.2003
(51) Int. Cl.: H01L 23/29, H01L 23/31, H01L 25/16

(54) **LEISTUNGSHALBLEITERMODUL**
POWER SEMICONDUCTOR MODULE
MODULE SEMI-CONDUCTEUR DE PUISSANCE

(30) Priorität: 27.11.2002 EP 02406028
(43) Veröffentlichungstag der Anmeldung: 24.08.2005
(73) Patentinhaber: ABB RESEARCH LTD., 8050 Zürich (CH)
(72) Erfinder: KNAPP, Wolfgang, CH-5600 Lenzburg (CH); KESER, Helmut, CH-5443 Niederrohrdorf (CH)
(74) Vertreter: ABB Patent Attorneys
(86) Internationale Anmeldenummer: PCT/CH2003/000700
(87) Internationale Veröffentlichungsnummer: WO 2004/049433

(56) Entgegenhaltungen:
- EP-A- 0 637 839
- EP-A- 0 903 790
- EP-A- 0 921 565
- EP-A- 0 936 671
- EP-A- 1 032 042
- WO-A-99/38196
- DE-A- 10 006 211
- DE-A- 19 625 240
- US-A- 5 776 406
- US-B1- 6 393 130

## Beschreibung

### Technisches Gebiet

Die Erfindung bezieht sich auf das Gebiet der Leistungshalbleitertechnik. Sie geht aus von einem Leistungshalbleitermodul gemäss dem Oberbegriff des Anspruchs 1.

### Stand der Technik

Leistungshalbleitermodule, insbesondere mit als Bipolartransistoren mit jeweils isoliert angeordneter Ansteueretektrode ausgeführten elektrischen Leistungshalbleiterbauelementen, werden heute in einer Fülle von leistungselektronischen Schaltungen, insbesondere in Umrichterschaltungen, eingesetzt. Ein solches Leistungshalbleitermodul ist beispielsweise in der US 6,201,696 angegeben. Darin weist das Leistungshalbleitermodul ein Gehäuse auf, welches beispielweise einen Kunststoff umfasst. Als Kunststoff ist ein aushärtbarer Vergusskunststoff in Form eines Harzes, beispielsweise Epoxydharz, also ein Duroplast gewählt. Desweiteren ist eine Grundplatte vorgesehen, wobei auf der dem Gehäuse zugewandten Fläche der Grundplatte die bereits vorstehend erwähnten elektrischen Leistungshalbleiterbauelemente angeordnet sind und die elektrischen Leistungshalbleiterbauelemente üblicherweise auf dieser Fläche der Grundplatte über eine isolierende Schicht angebracht sind.

Nach der US 6,201,696 sind die elektrischen Leistungshalbleiterbauelemente, die isolierende Schicht und Teile dem Gehäuse zugewandten Fläche der Grundplatte in das durch das Epoxydharz gebildete Gehäuse eingegossen, wobei zusätzlich mit zumindest einem der elektrischen Leistungshalbleiterbauelemente verbundene Leistungsanschlusselemente mit dem Gehäuse vergossen sind und Anschlussenden der Leistungsanschlusselemente aus dem Gehäuse geführt sind.

Problematisch bei einem vorstehend beschriebenen und in der US 6,201,696 offenbarten Leistungshalbleitermodul ist, dass das Epoxydharz zur Ausformung des Gehäuses unter hoher Temperatur in der Grössenordnung 230°C und unter hohem Druck in der Grössenordnung 30 bis 150 bar in eine entsprechende Form eingebracht werden muss. Die Herstellung des Leistungshalbleitermoduls ist dadurch aus prozesstechnischer Sicht aufwendig, kompliziert und damit teuer. Desweiteren ist das ausgehärtete Epoxydharz durch den üblicherweise hohen Fülleranteil sehr spröde und demnach nahezu nicht elastisch deformierbar. Typischerweise weisen Epoxydharze eine Härte wesentlich grösser als 95 ShoreA beziehungsweise wesentlich grösser als 60 ShoreD bei Raumtemeperatur im ausgehärteten Zustand auf. Weiterhin weisen gefüllte Epoxydharze üblicherweise einen Längenausdehnungskoeffizienten (CTE(α1)) zwischen 10 und 25 ppm/K und einem Biegemodul (Flexural Modulus) von grösser als 5GPa auf. Bei Erwärmung des Gehäuses durch die eingegossenen elektrischen Leistungshalbleiterbauelemente kann es deshalb zu unerwünschten Spannungen kommen, wodurch Risse im Gehäuse entstehen. Die isolierende Wirkung des Gehäuses bezüglich der elektrischen Leistungshalbleiterbauelemente untereinander ist damit nicht mehr gewährleistet, wodurch es zu einer Beschädigung oder Zerstörung des Leistungshalbleitermoduls, insbesondere infolge eines Kurzschlusses, kommen kann. Darüber hinaus ist durch die Sprödigkeit des Gehäuses eine erhöhte Stoss- und Schlagempfindlichkeit des Leistungshalbleitermoduls gegeben, wodurch es bei Einsatz in einem rauhen Umfeld, d.h. beispielsweise bei hohen Beschleunigungskräften in Form von Rüttelbewegungen, zu den vorstehend bereits erwähnten Rissen mit den entsprechenden Folgen kommen kann. Ferner ist durch solche hohen Beschleunigungskräfte eine Rissbildung am Gehäuse im Austrittsbereich der Leistungsanschlusselemente möglich, so dass die Haltewirkung der Leistungsanschlusselemente durch das Gehäuse nicht mehr gegeben ist und es zu einem Abriss der Anschlusselemente kommen kann. Der Betrieb des Leistungshalbleitermoduls ist dann nicht mehr oder nicht mehr sinnvoll möglich. Bei Epoxydharzen kommt es aufgrund des Längenausdehnungskoeffizienten (CTE(α1)) zwischen 10 und 25 ppm/K und des Biegemoduls (Flexural Modulus) von grösser als 5GPa beim Aushärtevorgang sehr of zu starken Spannungen, wodurch ebenfalls Risse im Gehäuse entstehen können.

Weiterhin ist in der EP 0936 671 A1 sowie auch in der WO 99/38196 ebenfalls ein Leistungshalbleitermodul angegeben, welches als aushärtbaren Vergusskunststoff des Gehäuses ein Harz umfasst. Der in der WO 99/38196 verwendete aushärtbare Vergusskunststoff ist zudem ein Elastomer. Darüber hinaus ist in der US 5,776,406 die Verwendung eines Schmelzklebstoffes als Gehäuseersatz zur Einbindung von elektronischen Bauteilen und Schaltungen offenbart.

### Darstellung der Erfindung

Aufgabe der Erfindung ist es deshalb, ein Leistungshalbleitermodul anzugeben, welches bezüglich seines Gehäuses ein hohes Mass an elastischer Deformierbarkeit aufweist und prozesstechnisch sehr einfach herzustellen ist. Diese Aufgabe wird durch ein Leistungshalbleitermodul mit den Merkmalen des Anspruchs 1 gelöst. In den abhängigen Ansprüchen sind vorteilhafte Weiterbildungen der Erfindung angegeben.

Das erfindungsgemässe Leistungshalbleitermodul weist ein aus einem aushärtbaren Vergusskunststoff gebildetes Gehäuse und eine Grundplatte auf, wobei auf einem Teil der dem Gehäuse zugewandten Fläche der Grundplatte elektrische Leistungshalbleiterbauelemente über eine isolierende Schicht oder unmittelbar angebracht sind. Zumindest der Teil der dem Gehäuse zugewandten Fläche der Grundplatte mit den angebrachten elektrischen Leistungshalbleiterbauelementen ist mit dem Gehäuse vergossen. Erfindungsgemäss weist der aushärtbare Vergusskunststoff eine Härte in der Grössenordnung von 30 bis 95 ShoreA auf. Vorteilhaft weist das Gehäuse des Leistungshalbleitermoduls im ausgehärteten Zustand dadurch eine besonders hohe elastische Deformierbarkeit bei einem hohen Wärmeausdehnungskoeffizienten auf, so dass bei Erwärmung des Gehäuses durch die eingegossenen elektrischen Leistungshalbleiterbauelemente nahezu keine unerwünschten Spannungen und eine daraus resultierende Rissbildung im Gehäuse auftreten kann. Darüber hinaus ist das erfindungsgemäß Leistungshalbleitermodul durch die elastische Deformierbarkeit des Gehäuses weitestgehend schlag- und stoßunempfindlich, wodurch ein Einsatz des Leistungshalbleitermoduls in einem rauhen Umfeld, d.h. bei hohen Beschleunigungskräften in Form von Rüttelbewegungen, problemlos möglich ist. In einem solchen Umfeld ist die gewünschte Isolationswirkung des Gehäuses für die vergossenen elektrischen Leistungshalbleiterbauelemente untereinander und der elektrischen Leistungshalbleiterbauelemente gegenüber ausserhalb des Gehäuses aufgrund der vorstehend genannten geringen Wahrscheinlichkeit einer Rissbildung des Gehäuses nahezu stets gegeben.

Ferner weist das Gehäuse des erfindungsgemäßen Leistungshalbleitermoduls neben der beschriebenen elastischen Deformierbarkeit dennoch eine ausgezeichnete Festigkeit auf, so dass das Gehäuse beispielsweise problemlos zur Befestigung geklemmt werden kann, ohne dass es zu Rissen im Gehäuse kommt oder das Gehäuse berstet.

Diese und weitere Aufgaben, Vorteile und Merkmale der vorliegenden Erfindung werden aus der nachfolgenden detaillierten Beschreibung bevorzugter Ausführungsformen der Erfindung in Verbindung mit der Zeichnung offensichtlich.

### Kurze Beschreibung der Zeichnung

Es zeigen:
- Fig. 1: eine Schnittdarstellung einer ersten Ausführungsform eines erfindungsgemässen Leistungshalbleitermoduls und
- Fig. 2: eine Schnittdarstellung einer zweiten Ausführungsform des erfindungsgemässen Leistungshalbleitermoduls.

Die in der Zeichnung verwendeten Bezugszeichen und deren Bedeutung sind in der Bezugszeichenliste zusammengefasst aufgelistet. Grundsätzlich sind in den Figuren gleiche Teile mit gleichen Bezugszeichen versehen. Die beschriebenen Ausführungsformen stehen beispielhaft für den Erfindungsgegenstand und haben keine beschränkende Wirkung.

### Wege zur Ausführung der Erfindung

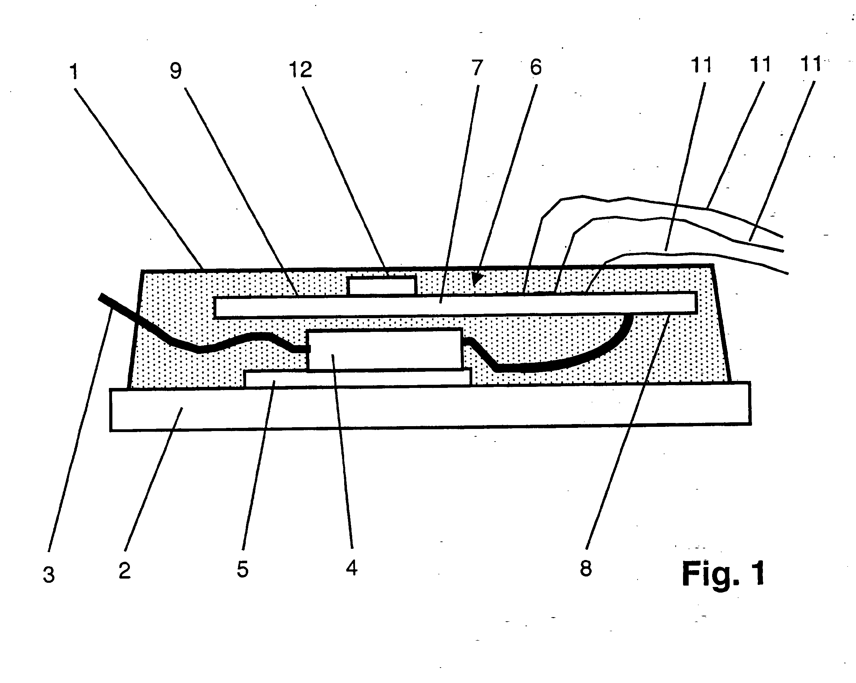

In Fig. 1 ist eine Schnittdarstellung einer ersten Ausführungsform eines erfindungsgemässen Leistungshalbleitermoduls dargestellt. Das erfindungsgemässe Leistungshalbleitermodul weist gemäss Fig. 1 ein aus einem aushärtbaren Vergusskunststoff gebildetes Gehäuse 1 und eine Grundplatte 2 auf, wobei auf einem Teil der dem Gehäuse 1 zugewandten Fläche der Grundplatte 2 elektrische Leistungshalbleiterbauelemente 4 über eine isolierende Schicht 5 angebracht sind. In Fig. 1 ist der Übersichtlichkeit halber nur ein solches elektrisches Leistungshalbleiterbauelement 4 gezeigt. Es ist aber auch denkbar, insbesondere für spezielle Anwendungen, dass die elektrischen Leistungshalbleiterbauelemente 4 anstelle über die isolierende Schicht 5 im wesentlichen direkt auf der dem Gehäuse 1 zugewandten Fläche der Grundplatte 2 angebracht sind, wodurch die isolierende Schicht 5 vorteilhaft eingespart werden kann. Gemäss Fig. 1 ist zumindest der Teil der dem Gehäuse 1 zugewandten Fläche der Grundplatte 2 mit den angebrachten elektrischen Leistungshalbleiterbauelementen 4 mit dem Gehäuse 1 vergossen. Erfindungsgemäss weist der aushärtbare Vergusskunststoff eine Härte in der Grössenordnung von 30 bis 95 ShoreA auf. Durch die Verwendung eines solchen Vergu'sskunststoffes weist das Gehäuse 1 des Leistungshalbleitermoduls im ausgehärteten Zustand eine besonders hohe elastische Deformierbarkeit bei einem hohen Wärmeausdehnungskoeffizienten auf. Bei Erwärmung des Gehäuses 1 durch die eingegossenen elektrischen Leistungshalbleiterbauelemente 4 bei deren Betrieb können somit vorteilhaft unerwünschten Spannungen und eine daraus resultierende Rissbildung im Gehäuse 1 weitestgehend verhindert werden. Ferner ist das erfindungsgemässe Leistungshalbleitermodul aufgrund der elastischen Deformierbarkeit des Gehäuses 1 weitestgehend schlag- und stoßunempfindlich. Ein Einsatz des Leistungshalbleitermoduls in einem rauhen Umfeld, d.h. bei hohen Beschleunigungskräften in Form von Rüttelbewegungen, ist somit problemlos möglich. Die gewünschte Isolationswirkung des Gehäuses 1 für die vergossenen elektrischen Leistungshalbleiterbauelemente 4 untereinander und der elektrischen Leistungshalbleiterbauelemente gegenüber außerhalb des Gehäuses 1 ist in einem solchen Umfeld aufgrund der vorstehend genannten geringen Wahrscheinlichkeit einer Rissbildung des Gehäuses 1 mit Vorteil nahezu stets gegeben.

Weiterhin weist das Gehäuse 1 des erfindungsgemässen Leistungshalbleitermoduls neben der beschriebenen elastischen Deformierbarkeit dennoch eine ausgezeichnete Festigkeit auf, so dass das Gehäuse 1 beispielsweise problemlos zur Befestigung an einem Körper geklemmt werden kann, ohne dass es zu Rissen im Gehäuse 1 kommt oder das Gehäuse 1 berstet.

Vorzugsweise weist der aushärtbare Vergusskunststoff einen Längenausdehnungskoeffizienten (CTE(α1)) zwischen 40 und 300 ppm/K und einem Biegemodul (Flexural Modulus) zwischen 100kPa und 2GPa auf. Im Gegensatz zu bekannten gefüllten Epoxydharzen kann durch den aushärtbaren Vergusskunststoff mit einen Längenausdehnungskoeffizienten (CTE(α1)) zwischen 40 und 300 ppm/K und einem Biegemodul (Flexural Modulus) zwischen 100kPa und 2GPa eine Rissbildung des Gehäuses beim Aushärtevorgang des Vergusskunststoffes weitestgehend vermieden werden. Auch lokale Erwärmungen innerhalb des Vergusses, z.B. durch die Leistungshalbleiterelemente, erzeugen dadurch keine gefährlichen Spannungen in deren Umgebung.

Es hat sich als besonders vorteilhaft erwiesen, dass der aushärtbare Vergusskunststoff ein thermoplastischer Schmelzklebstoff ist. Der thermoplastische Schmelzklebstoff enthält vorzugsweise ein Dimerfettsäurepolyamid. Dadurch ist eine besonders gute Isolationswirkung des Gehäuses 1 für die vergossenen elektrischen Leistungshalbleiterbauelemente 4 untereinander und der elektrischen Leistungshalbleiterbauelemente gegenüber ausserhalb des Gehäuses 1 gegeben.

Es hat sich als besonders vorteilhaft erwiesen, dass der Schmelzklebstoff eine Vergießtemperatur im Bereich zwischen 150°C und 220°C aufweist, um den Schmelzklebstoff in diesem Temperaturbereich zu vergießen. Weiterhin ist der Schmelzklebstoff vorteilhaft mit einem sehr niedrigen Vergießdruck im Bereich von 0,1MPa bis 0,5MPA vergießbar. Durch die flüssige Phase des Schmelzklebstoffes ist es möglich, diesen zu entgasen. Dadurch kann eine Blasenbildung während des Vergießvorgangs weitestgehend vermieden werden. Die Möglichkeit von auftretenden Teilentladungen während des Berieb des Leistungshalbleitermoduls infolge Luft- oder Gaseinschlüssen im Gehäuse 1 kann somit auf ein Minimum,reduziert werden. Die Formgebung des Gehäuses 1 wird vorzugsweise durch eine Aluminiumform erreicht. Beim Vergießvorgang des Schmelzklebstoff es härtet der Schmelzklebstoff zuerst an den Berührungsflächen der Form aus und fließt ansonsten bis zur vollständigen Aushärtung fortlaufend die Form. Durch die Fliesseigenschaften des Schmelzklebstoff es und die geringe Vergießtemperatur sowie den niedrigen Vergießdruckes ist eine hohe Dichtheit und Festigkeit des Gehäuses 1 erreicht, wobei die elektrischen Leistungshalbleiterbauelemente 4 und deren äußerst filigrane Aufbauten vorteilhaft vollständig und schonend eingegossen, abgedichtet, geschützt und in erwünschter Weise elektrisch gegeneinander isoliert werden.

Insgesamt ist das erfindungsgemäße Leistungshalbleitermodul, insbesondere das Gehäuse 1 aufgrund der geringen Vergießtemperatur und des niedrigen Vergießdruckes sowie durch die einfache Formgebung und die vorstehend genannte Fließfähigkeit des Schmelzklebstoffes während des Vergießvorgangs prozesstechnisch sehr einfach, insbesondere durch einfaches Gießen aber beispielsweise auch durch Spritzen, herstellbar.

Anstelle der Verwendung des thermoplastischen Schmelzklebstoffes als aushärtbarer Vergusskunststoff ist es auch denkbar, ein Polyurethan oder ein Silikon als aushärtbare Vergusskunststoff zu verwenden. Es versteht sich, dass die vorstehend bei Verwendung des thermoplastischen Schmelzklebstoffes als aushärtbarer Vergusskunststoff angegebenen Vorteile auch für ein Polyurethan oder ein Silikon als aushärtbarer Vergusskunststoff gelten.

Gängigerweise werden die elektrischen. Leistungshalbleiterbauelemente 4 von einer Ansteuereinrichtung 6 angesteuert, welche beispielsweise eine Ansteuerelektrodenstufe aufweist, falls die elektrischen Leistungshalbleiterbauelemente 4 als Bipolartransistoren mit jeweils isoliert angeordneter Ansteuerelektrode ausgeführt sind. Die Ansteuereinrichtung ist somit, wie in Fig. 1 gezeigt, mit den elektrischen Leistungshalbleiterbauelementen 4 verbunden. Gemäss Fig. 1 weist das erfindungsgemässe Leistungshalbleitermodul eine solche mit mindestens einem der elektrischen Leistungshalbleiterbauelemente 4 verbundene Ansteuereinrichtung 6 auf, welche zumindest teilweise mit dem Gehäuse 1 vergossen ist. Gemäss Fig. 1 ist die Ansteuereinrichtung 6 beispielsweise vollständig in das Gehäuse 1 eingegossen. Die Ansteuereinrichtung 6 ist dadurch in das Leistungshalbleitermodul integriert und durch die elastische Deformierbarkeit des Gehäuses 1 vor mechanischen Einwirkungen geschützt. Weiterhin kann der Platzbedarf des Leistungshalbleitermoduls zusammen mit der Ansteuereinrichtung 6 durch die vorstehend genannte Integration der Ansteuereinrichtung 6 in das Gehäuse 1 erheblich verringert werden. Darüber hinaus ist die Verbindung der Ansteuereinrichtung 6 mit mindestens einem der elektrischen Leistungshalbleiterbauelemente 4 durch die Integration der Ansteuereinrichtung 6 in das Gehäuse 1 sehr kurz ausgeführt. Dadurch kann vorteilhaft Leitungsmaterial eingespart werden, wobei zusätzlich die Störanfälligkeit des Leistungshalbleitermoduls durch weitestgehende Vermeidung der Möglichkeit einer Einkopplung unerwünschter elektromagnetischer Wellen verringert wird. Durch den geringen Vergussdruck können auch Bauteile umschlossen werden, die nicht für einen Druckverguss vorgesehen sind wie z.B. Becher-Elektrolytkondensatoren.

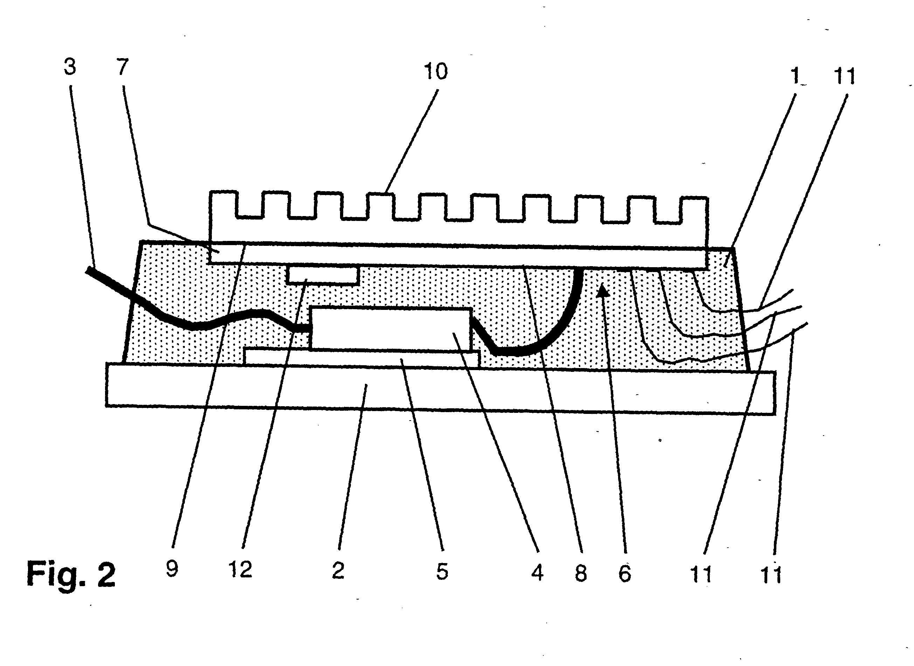

In Fig. 2 ist eine Schnittdarstellung einer zweiten Ausführungsform des erfindungsgemäßen Leistungshalbleitermoduls gezeigt. Gemäss Fig. 1 und Fig. 2 weist die Ansteuereinrichtung 6 eine Leiterplatte 7 mit einer den elektrischen Leistungshalbleiterbauelementen 4 zugewandten ersten Leiterplattenfläche 8 und mit einer den elektrischen Leistungshalbleiterbauelementen 4 abgewandten zweiten Leiterplattenfläche 9 auf. Im Unterschied zu Fig. 1 ist die Ansteuereinrichtung 6 gemäss Fig. 2 nur teilweise mit dem Gehäuse vergossen, d.h., dass die erste Leiterplattenfläche 8 mit dem Gehäuse 1 vergossen ist und die zweite Leiterplattenfläche 9 ausserhalb des Gehäuses 1 liegt. Die Ausführungsform des erfindungsgemäßen Leistungshalbleitermoduls gemäss Fig. 2 zeichnet sich vor allem dadurch aus, dass überschüssige Verlustwärmeenergie der elektrischen Leistungshalbleiterbauelemente 4 vom Inneren des Gehäuses 1 über die zweite Leiterplattenfläche 9 abgeführt werden kann. Zur weiteren Verbesserung der Abführung der angesprochenen Verlustwärmeenergie ist die zweite Leiterplattenfläche 9 gemäss Fig. 2 vorzugsweise mit einem Kühlelement 10 thermisch kontaktiert.

Gemäss Fig. 1 und Fig. 2 sind mit der Ansteuereinrichtung 6 verbundenen Ansteueranschlusselemente 11 mit dem Gehäuse 1 vergossen, wobei Anschlussenden der Ansteueranschlusselemente 11 aus dem Gehäuse 1 geführt sind. Die Ansteueranschlusselemente 11 dienen der Übertragung von Signalen beispielsweise einer übergeordneten Leitelektronikeinheit. Vorteilhaft sind die Ansteueranschlusselemerite 11 als Kabel ausgebildet. Solche Kabel sind flexibel ausgebildet, wodurch eine Rissbildung am Gehäuse 1 im Austrittsbereich der Ansteueranschlusselemente 11 bei auftretenden hohen Beschleunigungskräften beispielsweise bei Einsatz in einem rauhen Umfeld weitestgehend verhindert werden kann. Als Kabel für die Ansteueranschlusselemente 11 haben sich sowohl Kabel mit elektrischen Leitern als auch Lichtwellenleiter bewährt.

Es hat sich weiterhin als vorteilhaft erwiesen, dass der aushärtbare Vergusskunststoff, insbesondere der Schmelzklebstoff aber auch das erwähnte Polyurethan oder das Silikon im ausgehärteten Zustand im wesentlichen transparent oder opak ist, wodurch eine optische Kommunikation durch das Gehäuse 1 zu in Fig. 1 und Fig. 2 der Übersichtlichkeit nicht dargestellten optischen Empfangselementen der Ansteuereinrichtung 6 und/oder eine optische Kommunikation durch das Gehäuse 1 von in Fig. 1 und Fig. 2 der Übersichtlichkeit nicht dargestellten optischen Sendeelementen der Ansteuereinrichtung 6 ermöglicht ist. Die vorstehend genannten Elemente zur optische Kommunikation können anstelle der Ansteueranschlusselemente 11 oder zusätzlich zu den Ansteueranschlusselementen 11 vorgesehen sein.

Gemäss Fig. 1 und Fig. 2 ist ein mit einem der elektrischen Leistungshalbleiterbauelemente 4 verbundenes Leistungsanschlusselement 3 mit dem Gehäuse 1 vergossen. Das Leistungsanschlusselement 3 dient der Übertragung elektrischer Energie beziehungsweise Leistung über das elektrische Leistungshalbleiterbauelement 4. Allgemein ist mindestens ein mit mindestens einem der elektrischen Leistungshalbleiterbauelemente 4 verbundenes Leistungsanschlusselement 3 mit dem Gehäuse 1 vergossen, wobei ein Anschlussende des mindestens einen Leistungsanschlusselementes 3 aus dem Gehäuse 1 geführt ist. Weiterhin ist das mindestens eine Leistungsanschlusselement 3 vorzugsweise als Kabel ausgebildet. Diese Kabel sind flexibel ausgebildet, wodurch eine Rissbildung am Gehäuse 1 im Austrittsbereich des Leistungsanschlusselementes 3 bei auftretenden hohen Beschleunigungskräften beispielsweise bei Einsatz in einem rauhen Umfeld weitestgehend verhindert werden kann. Im folgenden wird näher auf den für das Gehäuse 1 verwendeten aushärtbaren Vergusskunststoff, den thermoplastischen Schmelzklebstoff, eingegangen. Der verwendete aushärtbare Vergusskunststoff, (der thermoplastische Schmelzklebstoff) hat die vorteilhafte Eigenschaft, dass zwischen dem aushärtbaren Vergusskunststoff, (dem thermoplastischen Schmelzklebstoff) und einem Substrat eine mechanische Verkrallung beziehungsweise mechanische Verankerung, d.h. mit allen eingegossenen und teilweise eingegossenen Komponenten stattfindet. Vor allem die als Kabel ausgeführten Ansteueranschlusselemente 11 und das mindestens eine Leistungsanschlusselement 3 sind durch die Haftwirkung des ausgehärteten Vergusskunststoffes (des thermoplastischen Schmelzklebstoffes) mit der zugehörigen Kabelisolierung besonders fest mit dem Gehäuse 1 verbunden. Aber beispielsweise auch der Teil der dem Gehäuse 1 zugewandten Fläche der Grundplatte 2 mit den angebrachten elektrischen Leistungshalbleiterbauelementen 4 sowie die zumindest teilweise mit dem Gehäuse 1 vergossene Ansteuereinrichtung 6 sind durch die ausgezeichnete Haftwirkung des aushärtbaren Vergusskunststoffes (des thermoplastischen Schmelzklebstoffes) mit dem Gehäuse 1 fest verbunden. Gerade bei den Ansteueranschlusselementen 11 und dem mindestens einen Leistungsanschlusselement 3 ist dadurch insbesondere am Gehäuse 1 an den Austrittsbereichen der vorstehend genannten Elemente 3, 11 eine Rissbildung nahezu unmöglich und die Haltewirkung dieser Elemente 3, 11 durch das Gehäuse 1 nahezu stets gegeben. Die Verfügbarkeit des erfindungsgemässen Leistungshalbleitermoduls insgesamt ist dadurch bedeutend gesteigert. Die Haftwirkung kann durch geeignete Haftvermittler (Primer) oder Beschichtungen zusätzlich verbessert werden. Beschichtungen können auch nach dem Verguss auf dem ausgehärteten Gehäuse angebracht werden, beispielsweise als Diffusionssperre für Feuchtigkeit, als totale oder partielle Lichtabschattung oder auch für Beschriftungszwecke.

### Bezugszeichenliste

- 1: Gehäuse
- 2: Grundplatte
- 3: Leistungsanschlusselement
- 4: elektrisches Leistungshalbleiterbauelement
- 5: isolierende Schicht
- 6: Ansteuereinrichtung
- 7: Leiterplatte
- 8: erste Leiterplattenfläche
- 9: zweite Leiterplattenfläche
- 10: Kühlelement
- 11: Ansteueranschlusselement
- 12: elektronisches Bauteil

## Patentansprüche

1. Leistungshalbleitermodul mit einem aus einem aushärtbaren Vergusskunststoff gebildeten Gehäuse (1) und mit einer Grundplatte (2), wobei auf einem Teil der dem Gehäuse (1) zugewandten Fläche der Grundplatte (2) elektrische Leistungshalbleiterbauelemente (4) über eine isolierende Schicht (5) oder unmittelbar angebracht sind, und wobei zumindest der Teil der dem Gehäuse (1) zugewandten Fläche der Grundplatte (2) mit den angebrachten elektrischen Leistungshalbleiterbauelementen (4) mit dem Gehäuse (1) vergossen ist und der aushärtbare Vergusskunststoff im ausgehärteten Zustand eine Härte von 30 bis 95 ShoreA aufweist, **dadurch gekennzeichnet, dass** der aushärtbare Vergusskunststoff ein thermoplastischer Schmelzklebstoff ist, wobei der aushärtbare Vergusskunststoff einen Längenausdehnungskoeffizienten zwischen 40 und 300 ppm/K und einen Biegemodul zwischen 100kPa und 2GPa aufweist.

2. Leistungshalbleitermodul nach Anspruch 1, **dadurch gekennzeichnet, dass** der Schmelzklebstoff ein Dimerfettsäurepolyamid enthält.

3. Leistungshalbleitermodul nach einem der vorhergehenden Ansprüche, **dadurch gekennzeichnet, dass** der Schmelzklebstoff eine Vergießtemperatur im Bereich zwischen 150°C und 220°C aufweist.

4. Leistungshalbleitermodul nach einem der vorhergehenden Ansprüche, **dadurch gekennzeichnet, dass** der Schmelzklebstoff mit einem Vergießdruck im Bereich von 0,1 MPa bis 0,5MPA vergießbar ist.

5. Leistungshalbleitermodul nach einem der vorhergehenden Ansprüche, **dadurch gekennzeichnet, dass** der aushärtbare Vergusskunststoff im ausgehärteten Zustand im wesentlichen transparent ist.

6. Leistungshalbleitermodul nach Anspruch 1 **dadurch gekennzeichnet, dass** eine mit mindestens einem der elektrischen Leistungshalbleiterbauelemente (4) verbundene Ansteuereinrichtung (6) zumindest teilweise mit dem Gehäuse (1) vergossen ist.

7. Leistungshalbleitermodul nach Anspruch 6, **dadurch gekennzeichnet, dass** die Ansteuereinrichtung (6) eine Leiterplatte (7) mit einer den elektrischen Leistungshalbleiterbauelementen (4) zugewandten ersten Leiterplattenfläche (8) und mit einer den elektrischen Leistungshalbleiterbauelementen (4) abgewandten zweiten Leiterplattenfläche (9) aufweist,
dass die erste Leiterplattenfläche (8) mit dem Gehäuse (1) vergossen ist, und
dass die zweite Leiterplattenfläche (9) ausserhalb des Gehäuses (1) liegt.

8. Leistungshalbleitermodul nach Anspruch 7, **dadurch gekennzeichnet, dass** die zweite Leiterplattenfläche (9) mit einem Kühleelement (10) thermisch kontaktiert ist.

9. Leistungshalbleitermodul nach Anspruch 6, **dadurch gekennzeichnet, dass** mit der Ansteuereinrichtung (6) verbundene Ansteueranschlusselemente (11) mit dem Gehäuse (1) vergossen sind und Anschlussenden der Ansteueranschlusselemente (11) aus dem Gehäuse (1) geführt sind.

10. Leistungshalbleitermodul nach Anspruch 9, **dadurch gekennzeichnet, dass** die Ansteueranschlusselemente (11) als Kabel ausgebildet sind.

11. Leistungshalbleitermodul nach Anspruch 1, **dadurch gekennzeichnet, dass** mindestens ein mit mindestens einem der elektrischen Leistungshalbleiterbauelemente (4) verbundenes Leistungsanschlusselement (3) mit dem Gehäuse (1) vergossen ist, wobei ein Anschlussende des mindestens einen Leistungsanschlusselementes (3) aus dem Gehäuse (1) geführt ist, und
dass das mindestens eine Leistungsanschlusselement (3) als Kabel ausgebildet ist.

## Claims

1. A power semiconductor module with a casing (1) formed from a curable casting plastic and with a base plate (2), wherein on a part of the surface of the base plate (2) facing the casing (1) electric power semiconductor components (4) are attached over an insulating layer (5) or directly, and wherein at least the part of the surface of the base plate (2) facing the casing (1) is cast with the casing (1) with the attached electric power semiconductor components (4) and the curable casting plastic in the cured state has a hardness of 30 to 95 Shore A,
**characterized in that** the curable casting plastic is a thermoplastic hot-melt adhesive, wherein the curable casting plastic has a length expansion coefficient between 40 and 300 ppm/K and a flexural modulus between 100kPa and 2GPa.

2. The power semiconductor module according to claim 1, **characterized in that** the hot-melt adhesive contains a dimeric fatty acid polyamide.

3. The power semiconductor module according to any one of the preceding claims, **characterized in that** the hot-melt adhesive has a casting temperature in the range between 150 °C and 220 °C.

4. The power semiconductor module according to any one of the preceding claims, **characterized in that** the hot-melt adhesive can be cast in the range from 0.1 MPa to 0.5 MPa.

5. The power semiconductor module according to any one of the preceding claims, **characterized in that** the curable casting plastic in the cured state is essentially transparent.

6. The power semiconductor module according to claim 1, **characterized in that** a control facility (6) at least connected with one of the electric power semiconductor components (4) is at least partly cast with the casing (1).

7. The power semiconductor module according to claim 6, **characterized in that** the control facility (6) has a printed circuit board (7) with a first printed circuit board surface (8) facing the electric power semiconductor components (4) and with a second printed circuit board surface (9) facing away from the electric power semiconductor components (4),
that the first printed circuit board surface (8) is cast with the casing (1) and that the second printed circuit board surface (9) lies outside the casing (1).

8. The power semiconductor module according to claim 7, **characterized in that** the second printed circuit board surface (9) is thermally contacted with a cooling element (10).

9. The power semiconductor module according to claim 6, **characterized in that** control connection elements (11) connected with the control facility (6) are cast with the casing (1) and connection ends of the control connection elements (11) are led out of the casing (1).

10. The power semiconductor module according to claim 9, **characterized in that** the control connection elements (11) are designed as cables.

11. The power semiconductor module according to claim 1, **characterized in that** at least a power connection element (3) connected with at least one of the electric power semiconductor components (4) is cast with the casing (1), wherein a connection end of the at least one power connection element (3) is led out of the casing (1) and
that the at least one power connection element (3) is designed as a cable.

## Revendications

1. Module semi-conducteur de puissance comportant un boîtier (1) formé dans une matière plastique de scellement durcissable et comportant une plaque de socle (2), moyennant quoi sur une partie de la surface de la plaque de socle (2) tournée vers le boîtier des éléments semi-conducteurs de puissance électriques (4) sont montés directement ou par l'intermédiaire d'une couche isolante (5), et moyennant quoi au moins la partie de la surface de la plaque de socle (2) tournée vers le boîtier (1) est scellée au boîtier (1)avec les éléments semi-conducteurs de puissance électriques montés et la matière plastique de remplissage durcissable présente à l'état durci une dureté de 30 à 95 ShoreA, **caractérisé en ce que**
la matière plastique de remplissage durcissable est une colle fusible thermoplastique, moyennant quoi la matière plastique de remplissage durcissable présente un coefficient de dilatation longitudinale compris entre 40 et 300 ppm/K et un module de flexion entre 100kPa et 2GPa.

2. Module semi-conducteur de puissance selon la revendication 1, **caractérisé en ce que** la colle fusible contient un polyamide à acide gras de dimère.

3. Module semi-conducteur de puissance selon une des revendications précédentes, **caractérisé en ce que** la colle fusible présente une température de scellement comprise ente 150°C et 220°.

4. Module semi-conducteur de puissance selon une des revendications précédentes, **caractérisé en ce que** la colle fusible peut être scellée à une pression de scellement comprise entre 0,1 MPa et 0,5 MPa.

5. Module semi-conducteur de puissance selon une des revendications précédentes, **caractérisé en ce que** la matière plastique de scellement durcissable est essentiellement transparente à l'état durci.

6. Module semi-conducteur de puissance selon la revendication 1, **caractérisé en ce que** un dispositif de commande (6) relié à au moins un des éléments semi-conducteurs de puissance électriques (4) est scellé au moins partiellement au boîtier (1).

7. Module semi-conducteur de puissance selon la revendication 6, **caractérisé en ce que** le dispositif de commande (6) présente une carte de circuit imprimé (7) comportant une première surface de circuit imprimé (8) tournée vers les éléments semi-conducteurs de puissance électriques (4) et comportant une deuxième surface de circuit imprimé (9) qui se détourne des éléments semi-conducteurs de puissance électriques,
**en ce que** la première surface de circuit imprimé (8) est scellée au boîtier (1) et **en ce que** la deuxième surface de circuit imprimé (9) est située à l'extérieur du boîtier (1).

8. Module semi-conducteur de puissance selon la revendication 7, **caractérisé en ce que** la deuxième surface de circuit imprimé (9) est contactée thermiquement par un élément de refroidissement (10).

9. Module semi-conducteur de puissance selon la revendication 6, **caractérisé en ce que** les éléments de raccordement de commande (11) reliés au dispositif de commande (6) sont scellés au boîtier (1) et des extrémités de raccordement des éléments de raccordement de commande (11) ressortent à l'extérieur du boîtier (1).

10. Module semi-conducteur de puissance selon la revendication 9, **caractérisé en ce que** les éléments de raccordement de commande (11) sont configurés comme des câbles.

11. Module semi-conducteur de puissance selon la revendication 1, **caractérisé en ce que** au moins un élément de raccordement de puissance (3) relié à au moins un des éléments semi-conducteurs de puissance électrique est scellé au boîtier (1), moyennant quoi une extrémité de raccordement d'au moins un élément de raccordement de puissance (3) ressort à l'extérieur du boîtier (1), et
**en ce que** au moins un élément de raccordement de puissance (3) est configuré comme un câble.
